# EUROPEAN PATENT SPECIFICATION

(11) **EP 3 553 212 B1**
(45) Date of publication and mention of the grant of the patent: **26.01.2022**
(21) Application number: 19167995.0
(22) Date of filing: 08.04.2019
(51) Int. Cl.: C30B 19/02, C30B 19/04, C30B 19/06, C30B 19/12, C30B 29/28, G02F 1/09, G02F 1/00, C01F 17/34

(54) **METHOD OF MANUFACTURING A GARNET TYPE CRYSTAL**
VERFAHREN ZUR HERSTELLUNG EINES GRANATARTIGEN KRISTALLS
PROCÉDÉ DE FABRICATION D'UN CRISTAL DE TYPE GRENAT

(30) Priority: 09.04.2018 JP 2018074724
(43) Date of publication of application: 16.10.2019
(73) Proprietor: Shin-Etsu Chemical Co., Ltd., Tokyo 100-0004 (JP)
(72) Inventor: Watanabe, Toshiaki, Annaka-shi, Gunma 379-0195 (JP)
(74) Representative: Vossius & Partner Patentanwälte Rechtsanwälte mbB

(56) References cited:
- US-A- 5 245 689
- US-A- 5 756 225
- Y. ZORENKO ET AL: "Bi3+-Ce3+ energy transfer and luminescent properties of LuAG:Bi,Ce and YAG:Bi,Ce single crystalline films", JOURNAL OF LUMINESCENCE, vol. 134, 1 February 2013 (2013-02-01), pages 539-543, XP055610110, NL ISSN: 0022-2313, DOI: 10.1016/j.jlumin.2012.07.032

## Description

### BACKGROUND

### Technical Field

The present invention relates to a manufacturing method of a garnet type crystal to be used in a Faraday rotator or the like.

### Background Art

In the opto-processing technology or the optomeasuring technology using laser light, the laser oscillation is unstable when the laser light is reflected from the surface of the optical parts provided in the propagation path and the reflected light returns to the laser light source. In order to block such reflected and returned light, an optical isolator using a Faraday rotator which non-reciprocally rotates the polarization plane is used.

In recent years, opto-processing machines using Yb-doped fiber lasers have increased. In the Yb-doped fiber lasers, the output of the laser light is amplified by a fiber amplifier. For this reason, parts such as optical isolators and the materials thereof are required to exhibit resistance to amplified light with high power of 1 W or more.

As a material for a Faraday rotator exhibiting relatively high resistance to light with high power, Tb₃Ga₅O₁₂ (terbium-gallium-garnet: TGG) single crystal has been developed and put to practical use (see, for example, W. Zhang et al., Journal of Crystal Growth, 306, 2007, 195-199) .

In addition, Tb₃Sc₂Al₅O₁₂ (terbium-scandium-aluminum-garnet: TSAG) single crystal having a greater Verdet constant than TGG has also been investigated (see, for example, WO 2011/132668 A), but Sc₂O₃ as a raw material is expensive and there is thus a problem that the cost is high.

US5245689 discloses a method for forming a magneto-optical aluminum garnet waveguide by liquid phase epitaxy.

US5756225 discloses a method for manufacturing an aluminum garnet turbine engine blade, wherein an epitaxial aluminum garnet layer is deposited on an aluminum garnet body by liquid phase epitaxy.

Y. Zorenko et al., Journal of Luminescence 134 (2013) 539-543, 3+ 3+ 3+ 3+ shows double Bi -Ce -doped and separately Bi - and Ce -doped Y₃Al₅O₁₂ (YAG) and Lu₃Al₅O₁₂ (LuAG) single crystalline film (SCF) phosphors grown by liquid phase epitaxy method from a Bi₂O₃-based flux.

### SUMMARY OF THE INVENTION

### PROBLEMS TO BE SOLVED BY THE INVENTION

Tb₃Al₅O₁₂ (terbium-aluminum-garnet: TAG) single crystal has a greater Verdet constant than TGG and does not use expensive raw materials such as Sc₂O₃ but is an incongruent melting type compound and thus cannot be manufactured by a single crystal growth method such as the Czochralski method, and it has not been reported the crystal has successfully grown to a practical level.

In addition, TAG also has advantages of having a higher thermal conductivity and smaller thermal lens effect than TGG and TSAG as a Faraday rotator.

However, a Faraday rotator is required to have excellent properties such as Verdet constant and light transmittance, particularly, a Faraday rotator adapted to light with high power is required to have a high light transmittance. This is because the light energy absorbed in the Faraday rotator is converted into thermal energy to generate heat when the light transmittance is low, as a result, the Faraday rotation angle changes and this leads to deterioration of isolation and also problems such as deterioration of isolation caused as the scattered light hits peripheral parts such as the holding material and magnet of the Faraday rotator and heat generation in the peripheral parts are particularly concerned in the case of light with high power.

Accordingly, an object of the present invention is to provide a practical method for manufacturing TAG single crystal, a Faraday rotator having a high light transmittance and a high Verdet constant, and an optical isolator using the same.

### MEANS FOR SOLVING THE PROBLEMS

In order to solve the above problem, the method of manufacturing a garnet type crystal of the present invention brings a raw material solution into contact with a substrate formed of a Dy₃Al₅O₁₂ crystal and performs liquid phase epitaxial growth. The garnet type crystal is represented by (Tb_{3-x-y}RₓBi_{y})Al₅O₁₂ (R is one or more elements selected from Y or a lanthanoid (La, Ce, Pr, Nd, Pm, Sm, Eu, Gd, Tb, Dy, Ho, Er, Tm, Yb, or Lu), 3-x-y > 0, 0 ≤ x, and 0 ≤ y)).

In the present invention, it is preferable that Tb₄O₇ and Al₂O₃ are dissolved in the raw material solution at ratios of from 1.0 to 5.0 mol% and from 30.0 to 40.0 mol%, respectively.

In the present invention, it is preferable that an Al element is present in the raw material solution in an amount to be from 3.0 to 20.0 times an amount of a Tb element.

### EFFECT OF THE INVENTION

According to the present invention, it is possible to easily manufacture a garnet type crystal represented by (Tb_{3-x-y}RₓBi_{y})Al₅O₁₂ (R is one or more elements selected from Y or a lanthanoid (La, Ce, Pr, Nd, Pm, Sm, Eu, Gd, Tb, Dy, Ho, Er, Tm, Yb, or Lu), 3-x-y > 0, 0 ≤ x, and 0 ≤ y)).

In addition, it is possible to obtain a Faraday rotator having a high light transmittance and a high Verdet constant and to fabricate an optical isolator adapted to light with high power.

### BRIEF DESCRIPTION OF THE DRAWINGS

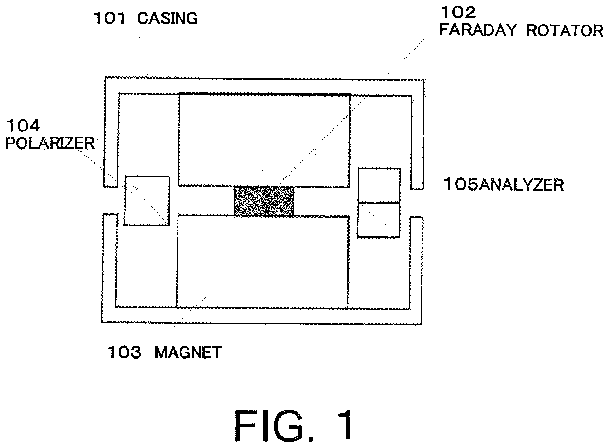

FIG. 1 is a schematic diagram which illustrates the structure of a general optical isolator.

### DETAILED DESCRIPTION OF THE EMBODIMENTS

The Faraday rotator of the present invention contains a garnet type crystal represented by (Tb_{3-x-y}RₓBi_{y}) Al₅O₁₂ (R is one or more elements selected from Y or a lanthanoid (La, Ce, Pr, Nd, Pm, Sm, Eu, Gd, Tb, Dy, Ho, Er, Tm, Yb, or Lu), Z 3-x-y > 0, 0 ≤ x, and 0 ≤ y)). In one embodiment, the present invention contains a garnet type crystal represented by (Tb_{3-x-y}RₓBi_{y})Al₅O₁₂ (R represents one or more elements selected from Y, Er, Yb, or Lu, 3-x-y > 0, 0 < x, and 0 ≤ y) .

In addition, the Faraday rotator of the present invention contains a garnet type crystal represented by (Tb_{3-x-y}RₓBi_{y})Al₅O₁₂ (R is one or more elements selected from Y or a lanthanoid (La, Ce, Pr, Nd, Pm, Sm, Eu, Gd, Tb, Dy, Ho, Er, Tm, Yb, or Lu), 3-x-y > 0, 0 ≤ x, and 0 < y)).

It is possible to improve the light transmittance by substituting part of Tb in Tb₃Al₅O₁₂ with one or more elements selected from Er, Yb, Lu, or Y.

In addition, it is possible to improve the Verdet constant by substituting part of Tb in Tb₃Al₅O₁₂ with Bi.

At this time, x is preferably 2.0 or less, more preferably 1.5 or less, and still more preferably 1.0 or less. The light transmittance increases while the Verdet constant decreases when x is increased. The Verdet constant decreases to be about 1/2 of that in a case in which x = 0 when x is set to 1.5 or more. In addition, the light transmittance is very slightly improved as compared with a decrease in the Verdet constant when x is set to 1.0 or more.

In addition, it is preferable to substitute part of Tb in Tb₃Al₅O₁₂ with one or more elements selected from Er, Yb, Lu, or Y and to substitute part of Tb in Tb₃Al₅O₁₂ with Bi (0 < x and 0 < y). In this manner, it is possible to improve the light transmittance without greatly decreasing the Verdet constant.

At this time, y is preferably 1.0 or less, more preferably 0.5 or less, and still more preferably less than 0.3. The light transmittance may be lower than that in a case in which x = 0 in some cases depending on the kind and substituted amount of R when y is 0.3 or more, but the light transmittance can be increased to be higher than that in a case in which x = 0 regardless of the kind and substituted amount of R when y is less than 0.3.

It is preferable that the light transmittance of the garnet type crystal represented by (Tb_{3-x-y}RₓBi_{y}) Al₅O₁₂ (R represents one or more elements selected from Y, Er, Yb, or Lu, 3-x-y > 0, 0 < x, and 0 < y) is set to be higher than the light transmittance of the garnet type crystal which is represented by Tb₃Al₅O₁₂ and is fabricated by the same method as that for this garnet type crystal represented by (Tb_{3-x-y}RₓBi_{y})Al₅O₁₂ by such a configuration.

In addition, the Verdet constant of the garnet type crystal is desirably as great as possible and is preferably a value to be at least 60% or more of the Verdet constant of the garnet type crystal which is represented by Tb₃Al₅O₁₂ and is fabricated by the same method as that for this garnet type crystal represented by (Tb_{3-x-y}RₓBi_{y})Al₅O₁₂. The Verdet constant is more preferably a value to be 70% or more and still more preferably a value to be 80% or more.

Here, the light transmittance is a light transmittance to be applied when the garnet type crystal is used as a Faraday rotator. As described above, TAG is assumed to be applied to a rare earth element-doped fiber laser, and the light transmittance is preferably a transmittance for light in the wavelength region (450 nm to 2150 nm) thereof and more preferably a transmittance for light in the wavelength region (1030 nm to 1100 nm) of an Yb-doped fiber laser.

In the same manner, the Verdet constant is a Verdet constant for light to be applied when the garnet type crystal is used as a Faraday rotator, and the Verdet constant is preferably a Verdet constant for light in the wavelength region (450 nm to 2150 nm) of the rare earth element-doped fiber laser and more preferably a Verdet constant for light in the wavelength region (1030 nm to 1100 nm) of a Yb-doped fiber laser.

The Faraday rotator of the present invention can be obtained by processing the garnet type crystal into a desired shape. The shape at that time is not particularly limited and can be a cylindrical shape, a prismatic shape, a rectangular parallelepiped shape, a flat plate shape, or the like.

By use of this Faraday rotator, it is possible to construct an optical isolator adapted to light with high power.

The optical isolator can have, for example, a structure as illustrated in FIG. 1.

In FIG. 1, a polarizer 104 and an analyzer 105 are disposed at both sides of a Faraday rotator 102 inside a casing 101. At this time, the polarization oscillation plane of the polarizer 104 and the polarization oscillation plane of the analyzer 105 are set so that the relative angle is 45°. In addition, a magnet 103 for applying a magnetic field to the Faraday rotator 102 is disposed around the Faraday rotator 102.

The light incident in the forward direction is polarized by the polarizer 104 and is incident on the Faraday rotator 102. Subsequently, the polarization plane of the light is rotated by 45° by the Faraday rotator 102 and is incident on the analyzer 105. The light is emitted as it is since the polarization oscillation plane of the polarizer 104 and the polarization oscillation plane of the analyzer 105 have a relative angle of 45°.

On the other hand, among the light incident from the opposite direction, polarized light which can pass through the analyzer 105 is incident on the Faraday rotator 102. In the Faraday rotator 102, the polarized light is rotated by 45° in the direction opposite to the forward direction with respect to the traveling direction. Here, the polarized light reached the polarizer 104 is at an angle of 90° with respect to the polarized transmission direction of the polarizer 104, and thus light incident from the opposite direction cannot pass through the optical isolator.

Incidentally, the optical isolator of the present invention is not particularly limited except the Faraday rotator to be used, and the structure, parts, and materials thereof can be arbitrarily selected as long as the functions as an optical isolator are exhibited.

The garnet type crystal represented by (Tb_{3-x-y}RₓBi_{y}) Al₅O₁₂ (R is one or more elements selected from Y or a lanthanoid (La, Ce, Pr, Nd, Pm, Sm, Eu, Gd, Tb, Dy, Ho, Er, Tm, Yb, or Lu), P 3-x-y > 0, 0 ≤ x, and 0 ≤ y)) can be manufactured by bringing a raw material solution into contact with a substrate formed of a Y₃Al₅O₁₂ (YAG) crystal (not in accordance with the invention) or a Dy₃Al₅O₁₂ (DAG) crystal and performing liquid phase epitaxial growth.

Liquid phase epitaxial growth (LPE) is a method in which crystals are deposited and grown on a substrate by bringing a raw material solution into contact with a substrate and gradually lowering the temperature of the solution to set a supersaturated state, and it is an advantageous method for growing a single crystal film having a large area and high quality. For the liquid phase epitaxial growth, there are methods such as a gradient method, a dipping method, and a sliding boat method, and a specific method is not particularly limited, but a dipping method is preferable since a thick film having a thickness of several hundred µm or more is easily grown.

The present invention is suitable for growing a crystal having a film thickness of several hundred µm or more, preferably 300 µm or more, more preferably 500 µm or more, and still more preferably 800 µm or more.

Specific examples of this manufacturing method are described below, but the present invention is not limited thereto.

First, raw materials are placed in a crucible at desired ratios and heated to be melted. At this time, Tb₄O₇, R₂O₃ (R is one or more elements selected from Y or a lanthanoid (La, Ce, Pr, Nd, Pm, Sm, Eu, Gd, Tb, Dy, Ho, Er, Tm, Yb, or Lu)), Al₂O₃, Bi₂O₃ and the like can be used as raw materials.

In addition, BaCo₃, B₂O₃, Bi₂O₃ and the like can be used as a flux. Bi is eventually incorporated into the grown crystal in a case in which Bi₂O₃ is used as a flux. When using Bi₂O₃, the Bi content in the grown crystal can be adjusted by concurrently using Bi₂O₃ with other fluxes. In addition, it is preferable to use B₂O₃ since the viscosity of flux increases and unintended miscellaneous crystals are hardly generated.

The raw material solution is preferably one in which Tb₄O₇ and Al₂O₃ are dissolved at ratios of from 1.0 to 5.0 mol% and from 30.0 to 40.0 mol%, respectively, and it is preferable that an Al element is present in the raw material solution in an amount to be from 3.0 to 20.0 times the amount of a Tb element. In this manner, it is possible to grow a garnet type crystal represented by (Tb_{3-x-y}RₓBi_{y}) Al₅O₁₂ by the LPE method.

It is preferable that the Al element is present in the raw material solution in an amount to be from 3.6 to 12.7 times the amount of the Tb element by containing Tb₄O₇ and Al₂O₃ in the raw material solution at from 1.5 to 4.6 mol% and from 34.0 to 38.0 mol%, respectively.

It is preferable to further contain R₂O₃ and Bi₂O₃ in the raw material solution at 3.0 mol% or less and 70.0 mol% or less, respectively, and it is preferable that an R element and a Bi element are present in the raw material solution in amounts to be 1.5 times or less and 35.0 times or less the amount of the Tb element, respectively.

It is preferable that the R element and Bi element are present in the raw material solution in amounts to be from 0.005 to 0.84 time and from 2.1 to 20.0 times the amount of the Tb element, respectively by containing R₂O₃ and Bi₂O₃ in the raw material solution at from 0.05 to 2.5 mol% and from 20.0 to 60.0 mol%.

This raw material solution is brought into contact with a substrate formed of a YAG crystal (not in accordance with the invention) or DAG crystal, and a crystal is epitaxially grown while lowering the solution temperature. Between the lattice constants of the DAG crystal (lattice constant: 12.038 Å) and YAG crystal (lattice constant: 12.000 Å), the lattice constant of the DAG crystal is closer to that of the TAG crystal (lattice constant: 12.074 Å), and it is possible to grow a crystal having high quality and a high light transmittance particularly when it is attempted to grow a relatively thick crystal. In addition, the Tb content in the grown crystal tends to increase when the DAG crystal is used as the substrate.

The crystal epitaxially grown on a substrate can be used as a Faraday rotator and the like by being subjected to the removal of the substrate and to desired processing.

### [Examples]

### <Example 1> (not in accordance with the invention)

The raw materials and fluxes were placed in a platinum crucible at ratios of Tb₄O₇: 3.9 mol%, Lu₂O₃: 0.1 mol%, Al₂O₃: 37.0 mol%, BaCo₃: 38.0 mol%, and B₂O₃: 21.0 mol%, melted at 1300°C, and stirred. Thereafter, the temperature was lowered to 1040°C, a substrate which was formed of a Y₃Al₅O₁₂ (YAG) crystal and had a diameter of 3 inches and a thickness of 1.0 mm was immersed in the liquid surface of the raw material solution, and a crystal was epitaxially grown while lowering the temperature from 1040°C to 1020°C.

A crystal having a thickness of 1.2 mm was obtained on the YAG substrate. This crystal was subjected to composition analysis by ICP-AES (inductively coupled plasma atomic emission spectrophotometry), and as a result, the composition of the grown crystal was Tb_{2.8}Lu_{0.2}Al₅O₁₂.

After the YAG substrate was ground and removed from the crystal, both surfaces of this crystal were polished to obtain a Tb_{2.8}Lu_{0.2}Al₅O₁₂ crystal having a thickness of 1.1 mm. This crystal was cut into a plate of 20 mm × 20 mm × 1.1 mm, and the polished surfaces of two crystal plates were bonded together by inorganic bonding. The inorganic bonding can be performed by activating the surfaces of crystals subjected to optical polishing (flatness of λ/8 or more, λ = 633 nm) with an argon atomic beam and pressurizing the crystals in a vacuum chamber at room temperature.

The crystal of 20 mm x 20 mm × 2.2 mm thus obtained was further processed to obtain a crystal of 2.2 mm × 2.2 mm × 20 mm and then fabricated into a Faraday rotator having a diameter (ϕ) of 2.0 mm × a length (L) of 18 mm.

The Verdet constant of this Faraday rotator measured using laser light having a wavelength of 1064 nm and an output of 1 W was 15 min/Oe·m, and the linear light transmittance thereof (without antireflection film on both end faces) was 78%.

A Faraday rotator was constructed by inserting a Faraday rotator (light transmittance: 94%) having both end faces coated with an antireflection film against air into a cylindrical Nd-Fe-B permanent magnet and disposing a polarizer at both ends. The insertion loss of this Faraday rotator was 0.6 dB and the isolation was 28 dB in the case of using laser light having a wavelength of 1064 nm and an output of 1 W.

### <Examples 2 to 10 and 24-30 (not in accordance with the invention), examples 11-23 and 31-37 (in accordance with the invention) and Reference Examples 1 to 9>

A crystal was grown by liquid phase epitaxial growth and the Verdet constant and light transmittance thereof were measured in the same manner as in Example 1. The various conditions for crystal growth and the measurement results of Verdet constant and light transmittance are presented in Tables 1 to 5.

In addition, optical isolators were constructed using part of the crystals fabricated and the insertion loss and isolation thereof were evaluated in the same manner as in Example 1.

**[Table 1]**

| | Substrate | Molar ratio of raw material [mol%] | | | | | | Temperature for melting | Temperature for crystal growth | Composition of crystal | Length of sample | Verdet constant | Light transmittance | Insertion loss | Isolation |
|---|---|---|---|---|---|---|---|---|---|---|---|---|---|---|---|
| | | Tb₄O₇ | R₂O₃ | Al₂O₃ | BaCo₃ | B₂O₃ | Bi₂O₃ | [°C] | [°C] | | [mm] | [min/Oe·m] | [%] | [dB] | [dB] |
| Example1 | YAG | 3.9 | 0.1 | 37.0 | 38.0 | 21.0 | - | 1300 | 1040→1020 | (Tb_{2.8}Lu_{0.2})Al₅O₁₂ | 17.0 | 15 | 78 | 0.6 | 28 |
| Example2 | YAG | 3.6 | 0.4 | 37.0 | 38.0 | 21.0 | - | 1300 | 1033→1016 | (Tb_{2.5}Lu_{0.5})Al₅O₁₂ | 18.0 | 14 | 82 | 0.2 | 33 |
| Example3 | YAG | 3.2 | 0.8 | 37.0 | 38.0 | 21.0 | - | 1300 | 1030→1016 | (Tb_{2.0}Lu_{1.0})Al₅O₁₂ | 18.0 | 11 | 84 | - | - |
| Example4 | YAG | 2.8 | 1.2 | 37.0 | 38.0 | 21.0 | - | 1300 | 1029→1015 | (Th_{1.5}Lu_{1.5})Al₅O₁₂ | 18.0 | 8 | 84 | - | - |
| Example5 | YAG | 3.0 | 1.0 | 36.0 | 40.0 | 20.0 | - | 1300 | 1033→1017 | (Tb_{2.1}Yb_{0.9})Al₅O₁₂ | 18.0 | 12 | 80 | - | - |
| Example6 | YAG | 2.7 | 1.3 | 36.0 | 40.0 | 20.0 | - | 1300 | 1032→1015 | (Tb_{1.8}Yb_{1.2})Al₅O₁₂ | 18.0 | 11 | 84 | - | - |
| Example7 | YAG | 1.9 | 2.1 | 36.0 | 40.0 | 20.0 | - | 1300 | 1040→1020 | (Tb_{1.4}Er_{1.6})Al₅O₁₂ | 18.0 | 8 | 79 | - | - |
| Example8 | YAG | 3.3 | 0.7 | 35.0 | 41.0 | 20.0 | - | 1300 | 1040→1025 | (Tb_{2.5}Y_{0.5})Al₅O₁₂ | 18.0 | 14 | 82 | 0.3 | 32 |
| Example9 | YAG | 2.7 | 1.3 | 34.0 | 42.0 | 20.0 | - | 1300 | 1043→1028 | (Tb_{2.0}Y_{1.0})Al₅O₁₂ | 18.0 | 11 | 78 | - | - |
| Example10 | YAG | 1.5 | 2.5 | 34.0 | 42.0 | 20.0 | - | 1300 | 1045→1028 | (Tb_{1.0}Y_{2.0})Al₅O₁₂ | 18.0 | 5 | 80 | - | - |
| Reference Example1 | YAG | 4.0 | - | 36.0 | 40.0 | 20.0 | | 1300 | 1040→1020 | Tb₃Al₅O₁₂ | 16.0 | 16 | 76 | 0.7 | 31 |

**[Table 2]**

| | Substrate | Molar ratio of raw material [mol%] | | | | | | Temperature for melting | Temperature for crystal growth | Composition of crystal | Length of sample | Verdet constant | Light transmittance | Insertion loss | Isolation |
|---|---|---|---|---|---|---|---|---|---|---|---|---|---|---|---|
| | | Tb₄O₇\| | R₂O₃ | Al₂O₃ | BaCo3 | B₂O₃ | Bi₂O₃ | [°C] | [°C] | | [mm] | [min/Oe·m] \| | [%] | [dB] | [dB] |
| Example11 | DAG | 3.95 | 0.05 | 38.0 | 37.0 | 21.0 | - | 1300 | 1030→1013 | (Tb_{2.9}Lu_{0.1})Al₅O₁₂ | 15.0 | 16 | 81 | 0.3 | 31 |
| Example12 | DAG | 3.9 | 0.1 | 37.0 | 38.0 | 21.0 | - | 1300 | 1029→1013 | (Tb_{2.8}Lu_{0.2})Al₅O₁₂ | 17.0 | 15 | 82 | 0.3 | 33 |
| Example13 | DAG | 3.2 | 0.8 | 37.0 | 38.0 | 21.0 | - | 1300 | 1027→1010 | (Tb_{2.0}Lu_{1.0})Al₅O₁₂ | 18.0 | 11 | 84 | - | - |
| Example14 | DAG | 3.5 | 0.5 | 37.0 | 38.0 | 21.0 | - | 1300 | 1035→1020 | (Tb_{2.5}Yb_{0.5})Al₅O₁₂ | 18.0 | 14 | 84 | 0.1 | 32 |
| Example15 | DAG | 2.9 | 1.1 | 37.0 | 38.0 | 21.0 | - | 1300 | 1033→1017 | (Tb_{2.0}Yb_{1.0})Al₅O₁₂ | 18.0 | 12 | 84 | - | - |
| Example16 | DAG | 3.4 | 0.6 | 36.0 | 40.0 | 20.0 | - | 1300 | 1035→1020 | (Tb_{1.8}Er_{0.5})Al₅O₁₂ | 18.0 | 13 | 82 | 0.3 | 33 |
| Example17 | DAG | 2.8 | 1.2 | 36.0 | 40.0 | 20.0 | - | 1300 | 1033→1018 | (Tb_{1.8}Er_{1.2})Al₅O₁₂ | 18.0 | 9 | 84 | - | - |
| Example18 | DAG | 3.3 | 0.7 | 36.0 | 40.0 | 20.0 | - | 1300 | 1038→1028 | (Tb_{2.5}Y_{0.5})Al₅O₁₂ | 20.0 | 13 | 82 | 0.3 | 34 |
| Exampte19 | DAG | 2.6 | 1.4 | 36.0 | 40.0 | 20.0 | - | 1300 | 1042→1027 | (Tb_{2.0}Y_{1.0})Al₅O₁₂ | 18.0 | 11 | 83 | - | - |
| Reference Example2 | DAG | 4.0 | | 36.0 | 40.0 | 20.0 | - | 1300 | 1035→1015 | Tb₃Al₅O₁₂ | 16.0 | 16 | 80 | 0.4 | 31 |
| Reference Example3 | DAG | 3.9 | 0.3 | 35.8 | 40.0 | 20.0 | | 1300 | 1036→1017 | (Tb_{2.8}Gd_{0.2})Al₅O₁₂ | 17.0 | 15 | 80 | 0.4 | 33 |
| Reference Example4 | DAG | 3.6 | 0.6 | 35.8 | 40.0 | 20.0 | | 1300 | 1036→1018 | (Tb_{2.6}Gd_{0.4})Al₅O₁₂ | 18.0 | 14 | 76 | 0.7 | 32 |
| Reference Example5 | DAG | 3.8 | 0.4 | 35.8 | 40.0 | 20.0 | - | 1300 | 1037→1015 | (Tb_{2.8}Eu_{0.2})Al₅O₁₂ | 17.0 | 15 | 68 | 0.9 | 30 |

From the results of Tables 1 and 2, it can be seen that the light transmittance is improved by substituting part of Tb in Tb₃Al₅O₁₂ with one or more elements selected from Er, Yb, Lu, or Y. In addition, the insertion loss when being fabricated into an optical isolator is also improved, and the isolation is improved in some cases.

**[Table 3]**

| | Substrate | Molar ratio of raw material [mol%] | | | | | | Temperature for melting | Temperature for crystal growth | Composition of crystal | Length of sample | Verdet constant | Light transmittance | Insertion loss | Isolation |
|---|---|---|---|---|---|---|---|---|---|---|---|---|---|---|---|
| | | Tb₄O₇ R₂O₃ | | Al₂O₃ | BaCo₃ | B₂O₃ | Bi₂O₃ | [°C] | [°C] | | [mm] | [min/Oe·m] | [%] | [dB] | [dB] |
| Example20 | DAG | 4.0 - | | 36.0 | 12.0 | 3.0 | 45.0 | 1180 | 920→905 | (Tb_{2.9}Bi_{0.1})Al₅O₁₂ | 13.0 | 17 | 79 | 0.5 | 35 |
| Example21 | DAG | 4.0 | - | 36.0 | - | - | 60.0 | 1150 | 865→850 | (Tb_{2.8}Bi_{0.2})Al₅O₁₂ | 12.0 | 18 | 74 | 0.6 | 34 |
| Example22 | DAG | 3.9 | 0.2 | 35.9 | 12.0 | 3.0 | 45.0 | 1180 | 916→900 | (Tb_{2.8}Gd_{0.1}Bi_{0.1})Al₅O₁₂ | 15.0 | 16 | 81 | 0.4 | 35 |
| Example23 | DAG | 4.0 | 0.2 | 35.8 | - | - | 60.0 | 1150 | 863→848 | (Tb_{2.8}Eu_{0.1}Bi_{0.1})Al₅O₁₂ | 15.0 | 16 | 80 | 0.4 | 36 |
| Reference Example2 | DAG | 4.0 | - | 36.0 | 40.0 | 20.0 | - | 1300 | 1035→1015 | Tb₃Al₅O₁₂ | 16.0 | 16 | 80 | 0.4 | 31 |
| Reference Example3 | DAG | 3.9 | 0.3 | 35.8 | 40.0 | 20.0 | - | 1300 | 1036→1017 | (Tb_{2.8}Gd_{0.2})Al₅O₁₂ | 17.0 | 15 | 80 | 0.4 | 33 |
| Reference Example4 | DAG | 3.6 | 0.6 | 35.8 | 40.0 | 20.0 | | 1300 | 1036→1018 | (Tb_{2.6}Gd_{0.4})Al₅O₁₂ | 18.0 | 14 | 76 | 0.7 | 32 |
| Reference Example5 | DAG | 3.8 | 04 | 35.8 | 40.0 | 20.0 | - | 1300 | 1037→1015 | (Tb_{2.8}Eu_{0.2})Al₅O₁₂ | 17.0 | 15 | 68 | 0.9 | 30 |

From the results in Table 3, it can be seen that the Verdet constant is improved by substituting part of Tb in Tb₃Al₅O₁₂ with Bi.

**[Table 4]**

| | Substrate | Molar ratio of raw material [mol%] | | | | | | Temperature for melting | Temperature for crystal growth | Composition of crystal | Length of sample | Verdet constant | Light transmittance | Insertion loss | Isolation |
|---|---|---|---|---|---|---|---|---|---|---|---|---|---|---|---|
| | | Tb₄O₇ | R₂O₃ | Al₂O₃ | BaCo₃ | B₂O₃ | Bi₂O₃ | [°C] | [°C] | | [mm] | [min/Oe·m] | [%] | [dB] | [dB] |
| Example24 | YAG | 4.3 | 0.2 | 38.0 | 10.0 | 2.5 | 45.0 | 1180 | 923→908 | (Tb_{2.6}Lu_{0.3}Bi_{0.1})Al₅O₁₂ | 17.0 | 15 | 78 | ' 0.5 | 35 |
| Example25 | YAG | 3.8 | 0.2 | 38.0 | 28.0 | 10.0 | 20.0 | 1220 | 965→950 | (Tb_{2.55}Lu_{0.3}Bi_{0.05})Al₅O₁₂ | 17.0 | 15 | 80 | 0.4 | 34 |
| Example26 | YAG | 4.1 | 0.4 | 38.0 | 10.0 | 2.5 | 45.0 | 1180 | 925→912 | (Tb_{2.4}Lu_{0.5}Bi_{0.1})Al₅O₁₂ | 18.0 | 14 | 79 | 0.4 | 33 |
| Example27 | YAG | 3.2 | 1.3 | 37.0 | 10.0 | 2.5 | 46.0 | 1180 | 924→910 | (Tb_{1.8}Yb_{1.1}Bi_{0.1})Al₅O₁₂ | 18.0 | 11 | 84 | 0.2 | 35 |
| Example28 | YAG | 2.9 | 1.1 | 37.0 | - | - | 59.0 | 1150 | 868→852 | (Tb_{1.7}Yb_{1.0}Bi_{0.3})Al₅O₁₂ | 18.0 | 12 | 83 | - | - |
| Example29 | YAG | 2.9 | 1.3 | 36.0 | 9.8 | 3.0 | 47.0 | 1180 | 923→908 | (Tb_{2.0}Er_{0.9}Bi_{0.1})Al₅O₁₂ | 20.0 | 13 | 84 | 0.1 | 34 |
| Example30 | YAG | 2.7 | 1.5 | 36.0 | 9.8 | 3.0 | 47.0 | 1180 | 924→912 | (Tb_{1.9}Er_{1.0}Bi_{0.1})Al₅O₁₂ | 18.0 | 10 | 82 | - | - |
| Reference Example1 | YAG | 4.0 | - | 36.0 | 40.0 | 20.0 | - | 1300 | 1040→1020 | Tb₃Al₅O₁₂ | 16.0 | 16 | 76 | 0.7 | 31 |
| Reference Example6 | YAG | 3.2 | 0.8 | 36.0 | - | - | 60.0 | 1150 | 870→855 | (Tb_{2.4}Lu_{0.3}Bi_{0.3})Al₅O₁₂ | 0.7 | 14 | 68 | - | - |
| Reference Example 7 | YAG | 3.1 | 0.9 | 36.0 | - | - | 60.0 | 1150 | 867→854 | (Tb_{2.2}Lu_{0.3}Bi_{0.5})Al₅O₁₂ | 20.0 | 13 | 60 | - | - |
| Reference Example8 | YAG | 2.9 | 1.1 | 37.0 | - | - | 59.0 | 1150 | 866→855 | (Tb_{2.0}Lu_{0.5}Bi_{0.5})Al₅O₁₂ | 20.0 | 13 | 72 | 0.8 | 32 |
| Reference Example9 | YAG | 3.0 | 1.0 | 37.0 | - | - | 59.0 | 1150 | 868→855 | (Tb_{1.5}Yb_{0.9}Bi_{0.5})Al₅O₁₂ | 20.0 | 13 | 61 | - | - |

**[Table 5]**

| | Substrate | Molar ratio of raw material [mol%] | | | | | | Temperature for melting | Temperature for crystal growth | Composition of crystal | Length of sample | Verdet constant | Light transmittance | Insertion loss | Isolation |
|---|---|---|---|---|---|---|---|---|---|---|---|---|---|---|---|
| | | Tb₄O₇ | R₇O₃ | Al₂O₃ | BaCo₃ | B₂O₃ | Bi₂O₃ | [°C] | [°C] | | [mm] | [min/Oe·m] | [%] | [dB] | [dB] |
| Example31 | DAG | 4.4 | 0.1 | 37.0 | - | - | 58.5 | 1150 | 862→850 | (Tb_{2.8}Lu_{0.1}Bi_{0.3})Al₅O₁₂ | 15.0 | 16 | 81 | 0.3 | 31 |
| Example32 | DAG | 3.8 | 0.7 | 37.0 | - | - | 58.5 | 1150 | 860→848 | (Tb_{2.0}Lu_{0.7}Bi_{0.3})Al₅O₁₂ | 20.0 | 13 | 84 | 0.4 | 36 |
| Example33 | DAG | 3.9 | 0.5 | 37.0 | - | - | 58.6 | 1150 | 857→840 | (Tb_{2.0}Lu_{0.5}Bi_{0.5})Al₅O₁₂ | 18.0 | 14 | 84 | 0.2 | 35 |
| Example34 | DAG | 4.6 | 0.4 | 36.0 | - | - | 59.0 | 1150 | 862→850 | (Th_{2.5}Yb_{0.3}Bi_{0.2})Al₅O₁₂ | 17.0 | 15 | 82 | 0.3 | 34 |
| Example35 | DAG | 3.9 | 1.1 | 36.0 | - | - | 59.0 | 1150 | 863→850 | (Tb_{2.0}Yb_{0.8}Bi_{0.2})Al₅O₁₂ | 20.0 | 13 | 84 | 0.2 | 33 |
| Example36 | DAG | 3.4 | 1.6 | 36.0 | - | - | 59.0 | 1150 | 860→847 | (Tb_{1.8}Er_{1.0}Bi_{0.2})Al₅O₁₂ | 18.0 | 10 | 84 | - | - |
| Example37 | DAG | 2.8 | 1.2 | 36.0 | 12.0 | 3.0 | 45.0 | 1180 | 926→910 | (Tb_{2.0}Y_{0.9}Bi_{0.1})Al₅O₁₂ | 20.0 | 13 | 83 | 0.3 | 32 |
| Reference Example2 | DAG | 4.0 | - | 36.0 | 40.0 | 20.0 | - | 1300 | 1035→1015 | Tb₃Al₅O₁₂ | 16.0 | 16 | 80 | 0.4 | 31 |

From the results of Tables 4 and 5, it can be seen that the light transmittance and Verdet constant are relatively high and the insertion loss and isolation are excellent when being fabricated into an optical isolator by substituting part of Tb in Tb₃Al₅O₁₂ with one or more elements selected from Er, Yb, Lu, or Y and Bi. It can be seen that it is particularly preferable to use DAG as the substrate.

It should be noted that embodiments of the present invention have been described above but the present invention is not limited to these examples.

## Claims

1. A method of manufacturing a garnet type crystal represented by (Tb_{3-x-y}RₓBi_{y})Al₅O₁₂ , wherein R is one or more elements selected from Y or a lanthanoid selected from La Ce, Pr, Nd, Pm, Sm, Eu, Gd, Tb, Dy, Ho, Er, Tm, Yb, or Lu, and wherein 3-x-y > 0, 0 ≤ x, and 0 ≤ y, wherein the method comprises bringing a raw material solution into contact with a substrate formed of a Dy₃Al₅O₁₂ crystal and performing liquid phase epitaxial growth.

2. The method of manufacturing a garnet type crystal according to claim 1, wherein Tb₄O₇ and Al₂O₃ are dissolved in the raw material solution at ratios of from 1.0 to 5.0 mol% and from 30.0 to 40.0 mol%, respectively.

3. The method of manufacturing a garnet type crystal according to claim 1 or 2, wherein an Al element is present in the raw material solution in an amount to be from 3.0 to 20.0 times an amount of a Tb element.

4. The method of manufacturing a garnet type crystal according to any one of claims 1 to 3, wherein the grown garnet type crystal represented by (Tb_{3-x-y}RₓBi_{y})Al₅O₁₂ has a film thickness of 300 µm or more.

5. The method of manufacturing a garnet type crystal according to any one of claims 1 to 4 further comprising processing the garnet type crystal into a Faraday rotator.

## Patentansprüche

1. Ein Verfahren zur Herstellung eines Kristalls von Granat-Typ, dargestellt durch (Tb_{3-x-y}RₓBi_{y})Al₅O₁₂, wobei R ein oder mehrere Elemente ist, ausgewählt aus Y oder einem Lanthanoid, ausgewählt aus La, Ce, Pr, Nd, Pm, Sm, Eu, Gd, Tb, Dy, Ho, Er, Tm, Yb oder Lu, und wobei 3-x-y > 0, 0 ≤ x und 0 ≤ y,
wobei das Verfahren das in Kontakt bringen einer Ausgangsmaterial-Lösung mit einem Substrat, gebildet aus einem Dy₃Al₅O₁₂-Kristall, und Durchführen eines Flüssigphasen-Epitaxiewachstums umfasst.

2. Das Verfahren zur Herstellung eines Kristalls von Granat-Typ gemäß Anspruch 1, wobei Tb₄O₇ und Al₂O₃ in der Ausgangsmaterial-Lösung jeweils in Verhältnissen von 1,0 bis 5,0 Mol-% und von 30,0 bis 40,0 Mol-% gelöst sind.

3. Das Verfahren zur Herstellung eines Kristalls von Granat-Typ gemäß Anspruch 1 oder 2, wobei ein Al-Element in der Ausgangsmaterial-Lösung in einer Menge vorhanden ist, die das 3,0- bis 20,0-Fache einer Menge eines Tb-Elements darstellt.

4. Das Verfahren zur Herstellung eines Kristalls von Granat-Typ gemäß einem der Ansprüche 1 bis 3, wobei der gewachsene, Kristall von Granat-Typ, dargestellt durch (Tb_{3-x-y}RₓBi_{y})Al₅O₁₂, eine Filmdicke von 300 µm oder mehr aufweist.

5. Das Verfahren zur Herstellung eines Kristalls von Granat-Typ gemäß einem der Ansprüche 1 bis 4, ferner umfassend das Verarbeiten des Kristalls von Granat-Typ zu einem Faraday-Rotator.

## Revendications

1. Méthode de fabrication d'un cristal de type grenat représenté par (Tb_{3-x-y}RₓBi_{y})Al₅O₁₂, dans laquelle R est un ou plusieurs éléments choisis parmi Y et un lanthanoïde choisi parmi La, Ce, Pr, Nd, Pm, Sm, Eu, Gd, Tb, Dy, Ho, Er, Tm, Yb ou Lu, et dans laquelle 3-x-y > 0,0 ≤ x, et 0 ≤ y, ladite méthode comprenant la mise en contact d'une solution de matières premières avec un substrat formé d'un cristal de Dy₃Al₅O₁₂ et la mise en œuvre d'une croissance épitaxiale en phase liquide.

2. Méthode de fabrication d'un cristal de type grenat selon la revendication 1, dans laquelle Tb₄O₇ et Al₂O₃ sont dissous dans la solution de matières premières en des proportions de 1,0 à 5,0 % en moles et de 30,0 % à 40,0 % en moles, respectivement.

3. Méthode de fabrication d'un cristal de type grenat selon la revendication 1 ou 2, dans laquelle de l'Al élémentaire est présent dans la solution de matières premières en une quantité devant être de 3,0 à 20,0 fois la quantité de Tb élémentaire.

4. Méthode de fabrication d'un cristal de type grenat selon l'une quelconque des revendications 1 à 3, dans lequel le cristal de type grenat ayant crû représenté par (Tb_{3-x-y}RₓBi_{y})Al₅O₁₂ a une épaisseur de film de 300 µm ou plus.

5. Méthode de fabrication d'un cristal de type grenat selon l'une quelconque des revendications 1 à 4, comprenant en outre le traitement du cristal de type grenat dans un rotateur de Faraday.
